# FASCICULE DE BREVET EUROPEEN

(11) **EP 0 717 495 B1**
(45) Date de publication et mention de la délivrance du brevet: **28.02.2001**
(21) Numéro de dépôt: 95410141.6
(22) Date de dépôt: 13.12.1995
(51) Int. Cl.: H03K 5/08, H04N 7/035

(54) **Circuit de restitution de bits transmis de manière asynchrone**
Schaltung zur Rückgewinnung von asynchron gesendeten Bits
Circuit for restitution of bits transmitted in an asynchronous fashion

(30) Priorité: 16.12.1994 FR 9415522
(43) Date de publication de la demande: 19.06.1996
(73) Titulaire: STMicroelectronics S.A., 94250 Gentilly (FR)
(72) Inventeur: Charvin, Jean-Pierre, F-38320 Eybens (FR); Stumpf, Christof c/o T.C.E.C., de Maupertuis F-38240 Meylan (FR)
(74) Mandataire: de Beaumont, Michel

(56) Documents cités:
- EP-A- 0 531 549
- US-A- 4 418 406
- US-A- 4 963 872
- US-A- 5 223 930

## Description

La présente invention concerne un circuit destiné à restituer les niveaux logiques de bits transmis par un signal de manière asynchrone et en série. La présente invention vise plus particulièrement un tel circuit permettant de restituer convenablement les bits même si le signal de transmission subit des fluctuations d'amplitude et de phase.

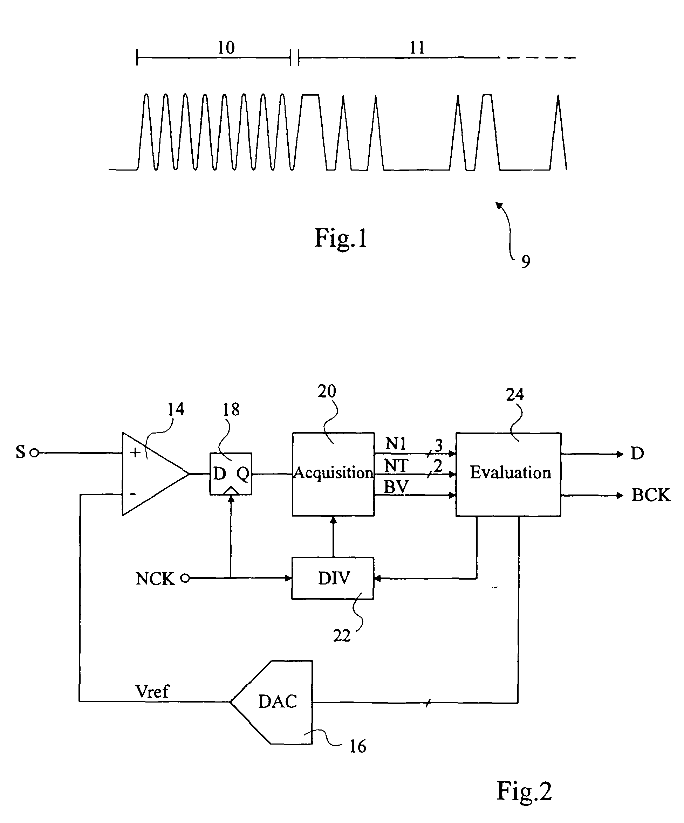

La figure 1 représente un exemple d'allure de signal de transmission. Cet exemple particulier de signal est utilisé pour transmettre des informations de télétexte. Chaque ligne d'informations de télétexte commence par une salve d'impulsions de synchronisation 10 suivie par les informations télétexte 11.

Selon les conditions de réception, un signal télétexte peut être bruité, et d'amplitude et de phase variables. Grâce aux impulsions de synchronisation 10 au début de chaque ligne de télétexte, le circuit de réception de ce signal peut réajuster périodiquement sa fréquence de réception et un seuil de discrimination destiné à distinguer les niveaux logiques hauts des niveaux logiques bas dans le signal télétexte.

Le brevet américain 5 136 382 décrit un tel circuit de réception de signaux télétexte. La fréquence et le seuil de discrimination trouvés en début de chaque ligne sont maintenus pendant toute la durée de la ligne, jusqu'à la salve d'impulsions de synchronisation suivante. Ainsi, ce circuit ne compense pas d'éventuelles fluctuations d'amplitude et de phase du signal télétexte pendant une ligne, ce qui peut provoquer de nombreuses erreurs si les conditions de réception ne sont pas optimales. Les signaux de télétexte peuvent provenir d'une bande de magnétoscope. La vitesse de transmission fluctue alors avec les variations de la vitesse de défilement de la bande.

Le brevet US-A-5 223 930 décrit un circuit de restitution de bits transmis par un signal asynchrone, dans lequel le niveau du signal est comparé à un niveau de référence et le résultat de cette comparaison est échantillonné un nombre prédéterminé de fois pendant chaque intervalle de temps correspondant à un bit.

Un objet de la présente invention est de prévoir un circuit permettant une compensation en continu de fluctuations d'amplitude et de phase ou fréquence d'un signal de transmission asynchrone de bits, la fréquence de transmission et le seuil de discrimination initiaux étant, soit fixés, soit déterminés périodiquement, comme dans le cas du télétexte, à l'aide de salves d'impulsions de synchronisation.

Pour atteindre cet objet, selon la présente invention, dans chaque fenêtre correspondant à un bit, on compte le nombre d'échantillons à une première valeur logique et le nombre de transitions des échantillons, et on corrige le niveau de référence et/ou les instants de début des fenêtres en fonction du nombre d'échantillons à la première valeur, du nombre de transitions, et d'une valeur frontière associée à une fenêtre adjacente.

Selon un mode de réalisation de la présente invention, lorsque le nombre de transitions dans une fenêtre courante est égal à 1, on avance l'instant de début d'une fenêtre ultérieure si le nombre majoritaire d'échantillons correspond à la valeur frontière, sinon on retarde l'instant de début d'une fenêtre ultérieure.

Selon un mode de réalisation de la présente invention, lorsque le nombre de transitions dans une fenêtre courante est égal à 2, on diminue le niveau de référence si le nombre d'échantillons à un niveau haut est inférieur au nombre prédéterminé d'une quantité prédéterminée et la valeur frontière est à un niveau bas, et on augmente le niveau de référence si le nombre d'échantillons à un niveau bas est inférieur au nombre prédéterminé d'une quantité prédéterminée et la valeur frontière est à un niveau haut.

Selon un mode de réalisation de la présente invention, une correction consistant dans l'avance ou le retard du début d'une fenêtre ultérieure, ou dans l'augmentation ou la diminution du niveau de référence, n'est effectuée que si la condition qui en est à l'origine présente un caractère répétitif.

Selon un mode de réalisation de la présente invention, on établit à une valeur prédéterminée le bit correspondant à une fenêtre si le nombre de transitions est égal à 2, le nombre d'échantillons à la valeur prédéterminée est au moins égal à 1, et la valeur frontière est égale au complément de la valeur prédéterminée. Dans les autres cas, on établit la valeur du bit à la valeur majoritaire des échantillons de la fenêtre.

Selon un mode de réalisation de l'invention, on effectue un ajustement initial de la période de succession des fenêtres et on maintient cette période pendant la transmission d'une série de bits. La valeur de chaque bit est déterminée par vote majoritaire sauf dans des cas où plusieurs valeurs frontière parmi la valeur du dernier échantillon de la fenêtre précédente, la valeur du dernier bit, la valeur du premier échantillon de la fenêtre suivante, et la valeur estimée du bit suivant sont représentatives de l'existence d'une impulsion courte du signal de transmission qui correspond à un bit isolé.

Ces objets, caractéristiques, et avantages ainsi que d'autres de la présente invention seront exposés plus en détail dans la description suivante de modes de réalisation particuliers, faite à titre non-limitatif à l'aide des figures jointes parmi lesquelles :
la figure 1, précédemment décrite, représente un exemple de signal de transmission de bits, commençant par une salve d'impulsions de synchronisation ;
la figure 2 représente schématiquement un mode de réalisation de circuit de restitution de bits selon la présente invention ; et
la figure 3 représente différents cas d'analyse, selon la présente invention, d'un signal de transmission.

Dans la figure 2, un signal S de transmission asynchrone de bits est fourni à une entrée non-inverseuse d'un comparateur 14. L'entrée inverseuse du comparateur 14 reçoit une tension de référence Vref fournie par un convertisseur numérique-analogique 16. Le convertisseur 16 sert à fournir un seuil de discrimination réglable correspondant à la tension Vref.

La sortie du comparateur 14 est échantillonnée par une bascule 18 à une fréquence NCK de période N fois inférieure à la durée nominale de transmission d'un bit, où N est un nombre de préférence impair, par exemple 7.

Un circuit d'acquisition 20 reçoit les échantillons de la bascule 18 et les examine dans des fenêtres successives dont la largeur correspond à la durée de transmission d'un bit. Les limites des fenêtres sont déterminées par des impulsions de synchronisation fournies par un diviseur 22. Le diviseur 22 reçoit la fréquence d'échantillonnage NCK et, dans des conditions normales, divise cette fréquence par N (7).

Dans chaque fenêtre, le circuit d'acquisition 20 compte le nombre N1 d'échantillons à l'état 1 et le nombre NT de transitions des échantillons. Les transitions comptées dans une fenêtre sont, par exemple, celles survenant entre le début du premier échantillon et celle survenant au début du dernier échantillon. Les nombres N1 et NT sont fournis à un circuit d'évaluation 24.

Selon un mode de réalisation, le circuit d'acquisition 20 fournit également au circuit d'évaluation 24 une valeur frontière BV qui, selon différentes variantes possibles, est la valeur LSV du dernier échantillon de la fenêtre précédente, la valeur LbV du bit précédent, la valeur NSV du premier échantillon de la fenêtre suivante, ou la valeur estimée NbV du bit suivant. Le circuit d'évaluation 24 se sert des valeurs N1, NT et BV pour déterminer la valeur D du bit correspondant à la fenêtre courante, une valeur de correction de phase qui se traduit par une modification du taux de division du diviseur 22, et une valeur de correction du seuil de discrimination Vref qui se traduit par une nouvelle valeur envoyée au convertisseur 16. Le circuit d'évaluation 24 fournit, le cas échéant, un signal de synchronisation BCK des bits fournis sur la sortie D.

La valeur du bit précédent LbV correspond à la sortie courante D du circuit d'évaluation 24, avant que la valeur du bit D correspondant à la fenêtre courante ne soit mise à jour. La valeur estimée du bit suivant NbV correspond au deuxième ou troisième échantillon de la fenêtre suivante. Cette valeur NbV est obtenue, par exemple, au niveau de la sortie du comparateur 14. En effet, au moment où le circuit d'évaluation 24 doit mettre à jour le bit D, la sortie du comparateur 14 est en avance de deux ou trois échantillons en raison de la présence de plusieurs bascules (par exemple 18) dans le chemin vers le circuit d'évaluation 24. Finalement, la valeur NSV du premier échantillon de la fenêtre suivante est prélevée à la sortie de la dernière bascule, par exemple 18, située dans le chemin vers le circuit d'évaluation 24.

Dans la présente description, on se base sur un exemple où chaque bit est échantillonné sept fois et où l'on prend en compte au maximum deux transitions des échantillons dans une fenêtre. Par conséquent, le nombre N1 est fourni au circuit d'évaluation 24 par un bus de trois bits et le nombre NT par un bus de deux bits.

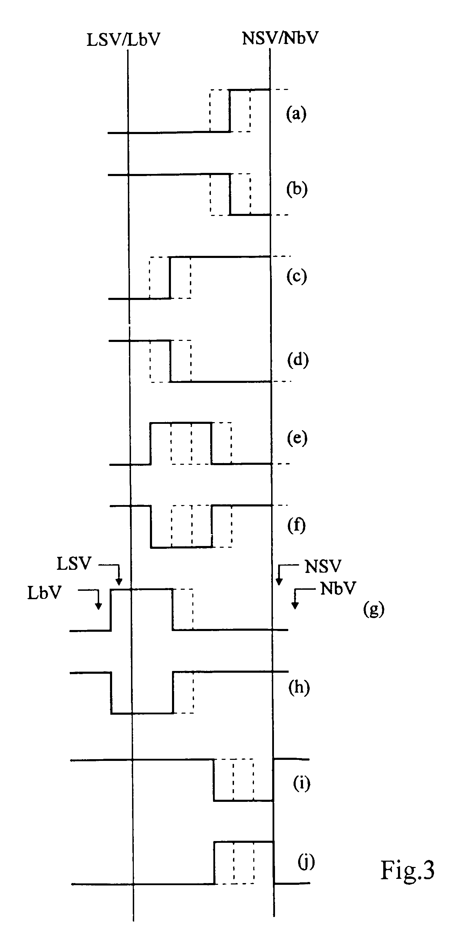

La figure 3 est destinée à illustrer, à titre d'exemple, comment le circuit d'évaluation 24 interprète, selon l'invention, différentes familles, numérotées de (a) à (j), de cas d'évolution d'échantillons à l'intérieur d'une fenêtre. La fenêtre est délimitée par deux lignes verticales. Une transition d'échantillon coïncidant avec le début d'une fenêtre est comptée dans cette fenêtre et la valeur frontière BV considérée est, par exemple, la valeur LSV du dernier échantillon de la fenêtre précédente. Chacune des autres valeurs frontière LbV, NSV et NbV pourrait être utilisée à la place de la valeur LSV.

La famille (a) correspond aux cas où il y a une seule transition, le dernier échantillon LSV de la fenêtre précédente est à 0, et au plus trois échantillons de la fenêtre courante sont à 1. Comme cela est illustré, la transition est montante et se produit au début du cinquième, sixième, ou septième échantillon.

La famille (b) correspond aux cas complémentaires de ceux de la famille (a). Il y a une seule transition, le dernier échantillon LSV de la fenêtre précédente est à 1, et au plus trois échantillons de la fenêtre courante sont à 0. Comme cela est illustré, la transition est descendante et se produit au début du cinquième, sixième, ou septième échantillon.

Les familles (a) et (b) correspondent à des cas où les fenêtres se succèdent en retard de phase par rapport à la transmission des bits. Le circuit d'évaluation 24 détecte cette situation par une simple analyse des valeurs N1, NT et LSV et commande le diviseur 22 pour réduire son taux de division. Ce taux de division passe, par exemple, de 7 à 6, ce qui a pour conséquence de raccourcir la fenêtre suivante, de manière à rapprocher sa fin de la fin normale du bit suivant.

La famille (c) correspond aux cas où il y a une seule transition, le dernier échantillon LSV de la fenêtre précédente est à 0, et au plus trois échantillons de la fenêtre courante sont à 0. Comme cela est illustré, la transition est montante et se produit au début du deuxième, troisième, ou quatrième échantillon.

La famille (d) correspond aux cas complémentaires de ceux de la famille (c). Il y a une seule transition, le dernier échantillon LSV de la fenêtre précédente est à 1, et au plus trois échantillons de la fenêtre courante sont à 1. Comme cela est illustré, la transition est descendante et se produit au début du deuxième, troisième, ou quatrième échantillon.

Les familles (c) et (d) correspondent aux cas où la succession des fenêtres est en avance de phase par rapport à la transmission des bits. Le circuit d'évaluation 24 détecte cette situation et commande le diviseur 22 pour augmenter son taux de division. Ce taux de division passe, par exemple, de 7 à 8. Ainsi, la fenêtre suivante est agrandie, ce qui a encore pour conséquence de rapprocher la fin de cette fenêtre de la fin normale du bit suivant.

La famille (e) correspond aux cas où il y a deux transitions, le nombre d'échantillons à 1 est au plus égal à 4, et le dernier échantillon LSV de la fenêtre précédente est à 0. La première transition, montante, coïncide éventuellement avec le début de la fenêtre, et la deuxième transition, descendante, peut survenir au plus tard au début du septième échantillon, et est distante de la première d'au plus quatre échantillons.

Cette famille (e) correspond aux cas où le seuil de discrimination Vref est de valeur trop importante. En effet, comme le montre la figure 1, les fronts du signal de transmission ont en général une pente relativement faible. Par conséquent, lorsque le seuil de discrimination est trop important, il y a plus d'échantillons à 0 qu'à 1 pour un unique bit à 1. Le circuit d'évaluation 24 détecte cette situation par une simple analyse des valeurs N1, NT et LSV et diminue le seuil de discrimination Vref en diminuant la valeur fournie au convertisseur numérique-analogique 16.

La famille (f) correspond aux cas complémentaires de ceux de la famille (e). Il y a deux transitions, le nombre d'échantillons à 0 est au plus égal à 4, et le dernier échantillon de la fenêtre précédente est à 1. La première transition, descendante, coïncide éventuellement avec le début de la fenêtre, et la deuxième transition, montante, peut survenir au plus tard au début du septième échantillon et est distante de la première d'au plus quatre échantillons.

Cette famille (f) correspond aux cas où le seuil de discrimination est trop bas. Le circuit d'évaluation 24 détecte cette situation et augmente le seuil de discrimination en augmentant la valeur fournie au convertisseur 16.

On peut envisager qu'une correction (modification de la largeur de fenêtre ou du seuil de discrimination) ne soit effectuée que si les conditions qui en sont à l'origine ont un caractère répétitif. C'est-à-dire, par exemple, la largeur de la fenêtre est diminuée dans la situation (a) seulement si cette situation se répète un nombre prédéterminé de fois. Pour cela, par exemple, on cumule un nombre représentatif de l'erreur à corriger à chaque fenêtre. Lorsque la valeur cumulée dépasse un seuil prédéterminé, la correction est effectuée et l'accumulation est réinitialisée. Le nombre N1 est représentatif de l'erreur dans les situations (a), (d) et (f), et la valeur 7-N1 est représentative de l'erreur dans les situations (b), (c) et (e). Dans les cas où l'on modifie le seuil de discrimination, cette modification peut être proportionnelle à la valeur représentative de l'erreur (N1 ou 7-N1).

La valeur D de chaque bit correspondant à une fenêtre est établie, par exemple, par vote majoritaire, c'est-à-dire qu'elle est établie à la valeur majoritaire des échantillons de la fenêtre correspondante. Cette règle est appliquée sauf dans les cas (e) où le nombre d'échantillons à 1 varie entre 1 et 3 et dans les cas (f) où le nombre d'échantillons à 0 varie entre 1 et 3. En effet, dans ces deux situations extrêmes, on suppose que le faible nombre d'échantillons à 1 ou à 0 indique quand même que le bit correspondant est à 1 ou à 0, car on suppose que ce faible nombre d'échantillons est provoqué par un seuil de discrimination trop élevé ou trop bas.

Selon une variante, la valeur D pourrait être la valeur de l'échantillon médian de la fenêtre.

Le signal de synchronisation de bits BCK correspond, par exemple, aux impulsions fournies par le diviseur 22.

Le mode de réalisation qui vient d'être décrit, qui effectue en permanence des corrections de phase et d'amplitude de seuil, s'applique à tout signal de transmission asynchrone de bits dont la fréquence de transmission et l'amplitude ont des valeurs nominales connues.

Le demandeur s'est aperçu, notamment dans une application au télétexte, qu'il vaut mieux régler la phase périodiquement de façon ponctuelle et ne plus corriger la phase pendant les transmissions des bits à récupérer. On tient alors mieux compte d'un effet de "retard de groupe" ("group delay") qui modifie brusquement et aléatoirement la phase d'une transition sans que la transition suivante soit affectée.

Ainsi, dans un deuxième mode de réalisation du circuit selon l'invention, on n'effectue pas de correction de phase pendant les transmissions des bits à récupérer. Dans l'exemple du traitement d'un signal télétexte (figure 1), la phase est ajustée pendant chaque salve de synchronisation 10, en synchronisant les fenêtres (déterminées par la sortie du diviseur 22) sur les transitions des impulsions de la salve 10. La phase obtenue à la fin de la salve 10 est validée au cours de la réception d'un code de début de transmission 11100100 (qui apparaît au début de l'intervalle 11 à la figure 1). Cette validation consiste à corriger la phase, de la manière décrite précédemment en relation avec les familles de cas (b) et (d), pour les deux premières transitions dans le code de début, c'est-à-dire entre 111 et 00 et entre 00 et 1. La phase alors obtenue est maintenue jusqu'à la prochaine salve 10. De préférence, on utilise la dernière valeur de bit LbV, et non la dernière valeur d'échantillon LSV, dans les corrections de phase.

Pour déterminer la valeur de chaque bit D, on utilise, selon les différents cas particuliers exposés ci-après, plusieurs des quatre valeurs frontière LSV, LbV, NSV et NbV.

Dans les cas de la famille (e), le bit D est affecté de l'état 1 si :
- le nombre N1 d'échantillons à 1 est compris entre 1 et 3 ;
- le nombre NT de transitions est égal à 2 ; et
- la dernière valeur de bit LbV et la dernière valeur d'échantillon LSV sont égales à 0.

Dans les cas de la famille (f), le bit D est affecté de l'état 0 si :
- le nombre N1 est compris entre 4 et 6 ;
- le nombre NT est égal à 2 ; et
- les valeurs LbV et LSV sont égales à 1.

Des familles de cas (g) et (h), illustrées à la figure 3, correspondent à des impulsions de courte durée commençant juste avant le début de la fenêtre courante et que l'on doit interpréter comme des bits isolés.

Dans les cas de la famille (g), le bit D est affecté de l'état 1 si :
- le nombre N1 est compris entre 2 et 3 ;
- le nombre NT est égal à 1 ;
- les valeurs LbV et LSV sont différentes ;
- la valeur LbV et la valeur de l'échantillon suivant NSV sont égales à 0.

Dans les cas de la famille (h), complémentaires aux cas de la famille (g), le bit D est affecté de l'état 0 si :
- le nombre N1 est compris entre 4 et 5 ;
- le nombre NT est égal à 1 ;
- les valeurs LbV et LSV sont différentes ;
- la valeur LbV et la valeur NSV sont égales à 1.

Dans les cas, non-représentés, symétriques de ceux des familles (g) et (h), c'est-à-dire pour des impulsions de courte durée se terminant juste après le début de la fenêtre suivante, le bit D est affecté de l'état 1 si :
- le nombre N1 est compris entre 2 et 3 ;
- le nombre NT est égal à 1 ;
- les valeurs LbV et LSV sont égales ;
- la valeur estimée NbV du bit suivant et la valeur NSV sont différentes ; et
- les valeurs LbV et NbV sont égales à 0 ;
et le bit D est affecté de l'état 0 si :
- le nombre N1 est compris entre 4 et 5 ;
- le nombre NT est égal à 1 ;
- les valeurs LbV et LSV sont égales ;
- les valeurs NbV et NSV sont différentes ; et
- les valeurs LbV et NbV sont égales à 1.

Des familles de cas (i) et (j) correspondent aux familles (e) et (f) dans les cas extrêmes où la deuxième transition survient au début de la fenêtre suivante, c'est-à-dire que cette deuxième transition n'est pas comptée dans la fenêtre courante.

Dans les cas de la famille (i), le bit D est affecté de l'état 1 si :
- le nombre N1 est compris entre 1 et 3 ;
- le nombre NT est égal à 1 ;
- les valeurs LbV, LSV, NbV, et NSV sont égales à 0.

Dans les cas de la famille (j), le bit D est affecté de l'état 0 si :
- le nombre N1 est compris entre 4 et 6 ;
- le nombre NT est égal à 1 ; et
- les valeurs LbV, LSV, NbV, et NSV sont égales à 1.

Dans tous les autres cas, l'état du bit D est déterminé par vote majoritaire.

Les corrections d'amplitude de seuil restent inchangées par rapport à ce qui a été décrit en relation avec les familles de cas (e) et (f), sauf que l'on utilise de préférence la dernière valeur de bit LbV au lieu de la dernière valeur d'échantillon LSV.

En outre, le seuil est de préférence réajusté pendant chaque salve de synchronisation 10. Pour cela, par exemple, le seuil est affecté d'une valeur basse au début de chaque salve 10 et le circuit d'évaluation 24 effectue des corrections pour ramener le nombre N1 d'échantillons à 1 dans deux fenêtres consécutives au nombre N d'échantillons d'une fenêtre (N=7 dans l'exemple décrit). Ces corrections sont, par exemple, proportionnelles à la différence N1-N. Pour limiter les possibilités d'oscillation, le coefficient de proportionnalité utilisé décroît pour les différences N1-N successives (par exemple, on utilise successivement les coefficients 16, 8, 4, 2 et 1).

De nombreuses variantes et modifications de la présente invention apparaîtront à l'homme du métier qui pourra, par exemple, augmenter le nombre de transitions comptées dans une fenêtre et diversifier les cas et les corrections à apporter.

## Revendications

1. Circuit de restitution de bits transmis par un signal (S) asynchrone, comprenant :
- un comparateur (14) du niveau du signal à un niveau de référence (Vref) ;
- un circuit d'échantillonnage (18) fournissant plusieurs (N) échantillons de la sortie du comparateur pour chaque intervalle de temps correspondant à un bit ;
- un circuit (22) pour déterminer une succession de fenêtres dont chacune correspond à un de ces bits;
caractérisé en ce qu'il comprend :
- un circuit d'acquisition (20) recevant les échantillons et fournissant, pour chaque fenêtre, le nombre (N1) d'échantillons qui ont une première valeur logique, le nombre (NT) de transitions des échantillons, et une valeur frontière (BV) associée à une fenêtre adjacente ; et
- un circuit d'évaluation (24) pour corriger le niveau de référence et/ou l'alignement des fenêtres sur les bits en fonction des sorties du circuit d'acquisition.

2. Procédé de restitution de bits transmis par un signal (S) de manière asynchrone, dans lequel le niveau du signal est comparé à un niveau de référence (Vref) et le résultat de cette comparaison est échantillonné un nombre prédéterminé (N) de fois pendant chaque intervalle de temps correspondant à un bit, caractérisé en ce qu'il comprend les étapes suivantes :
- dans chaque fenêtre correspondant à un de ces bits, compter le nombre (N1) d'échantillons à une première valeur logique et le nombre (NT) de transitions des échantillons ; et
- corriger le niveau de référence et/ou les instants de début des fenêtres, en fonction du nombre d'échantillons à la première valeur, du nombre de transitions, et d'une valeur frontière (BV) associée à une fenêtre adjacente.

3. Procédé de restitution de bits selon la revendication 2, caractérisé en ce qu'il comprend les étapes suivantes lorsque le nombre de transitions (NT) dans une fenêtre courante est égal à 1 :
- avancer l'instant de début d'une fenêtre ultérieure si le nombre majoritaire d'échantillons correspond à la valeur frontière (BV) ; sinon
- retarder l'instant de début d'une fenêtre ultérieure.

4. Procédé de restitution de bits selon la revendication 2, caractérisé en ce qu'il comprend les étapes suivantes lorsque le nombre de transitions (NT) dans une fenêtre courante est égal à 2 :
- diminuer le niveau de référence (Vref) si le nombre (N1) d'échantillons à un niveau haut est inférieur au nombre prédéterminé (N) d'une quantité prédéterminée et la valeur (BV) frontière est à un niveau bas ; et
- augmenter le niveau de référence si le nombre d'échantillons à un niveau bas est inférieur au nombre prédéterminé (N) d'une quantité prédéterminée et la valeur frontière est à un niveau haut.

5. Procédé de restitution de bits selon l'une quelconque des revendications 3 à 4, caractérisé en ce qu'une correction consistant dans l'avance ou le retard du début d'une fenêtre ultérieure, ou dans l'augmentation ou la diminution du niveau de référence (Vref), n'est effectuée que si la condition qui en est à l'origine présente un caractère répétitif.

6. Procédé de restitution de bits selon la revendication 2, caractérisé en ce qu'il comprend les étapes suivantes :
- établir à une valeur prédéterminée le bit correspondant à une fenêtre si le nombre de transitions (NT) est égal à 2, le nombre d'échantillons à la valeur prédéterminée est au moins égal à 1, et la valeur frontière est égale au complément de la valeur prédéterminée ; et
- dans les autres cas, établir la valeur du bit à la valeur majoritaire des échantillons de la fenêtre.

7. Procédé de restitution de bits selon la revendication 2, caractérisé en ce qu'il comprend les étapes suivantes :
- effectuer un ajustement initial de la période de succession des fenêtres et maintenir cette période pendant la transmission d'une série de bits (11) ; et
- déterminer la valeur de chaque bit par vote majoritaire sauf dans des cas où plusieurs valeurs frontière (BV) parmi la valeur du dernier échantillon de la fenêtre précédente (LSV), la valeur du dernier bit (LbV), la valeur du premier échantillon de la fenêtre suivante (NSV), et la valeur estimée du bit suivant (NbV) sont représentatives de l'existence d'une impulsion courte dudit signal qui correspond à un bit isolé.

8. Procédé de restitution de bits selon la revendication 7, caractérisé en ce qu'il comprend l'étape consistant à établir à une valeur prédéterminée le bit correspondant à une fenêtre si :
- une minorité d'échantillons est à ladite valeur prédéterminée,
- le nombre de transitions (NT) dans la fenêtre est égal à 1,
- le dernier échantillon (LSV) de la fenêtre précédente est à ladite valeur prédéterminée, et
- le bit précédent (LbV) et le premier échantillon (NSV) de la fenêtre suivante sont à la valeur complémentaire de ladite valeur prédéterminée.

9. Procédé de restitution de bits selon la revendication 7, caractérisé en ce qu'il comprend l'étape consistant à établir à une valeur prédéterminée le bit correspondant à une fenêtre si :
- une minorité d'échantillons est à ladite valeur prédéterminée,
- le nombre de transitions (NT) dans la fenêtre est égal à 1,
- le dernier échantillon (LSV) de la fenêtre précédente et le dernier bit (LbV) sont égaux,
- le bit estimé suivant (NbV) et le premier échantillon (NSV) de la fenêtre suivante sont différents, et
- le dernier bit (LbV) et le bit estimé suivant (NbV) sont à la valeur complémentaire de ladite valeur prédéterminée.

10. Procédé de restitution de bits selon la revendication 7, caractérisé en ce qu'il comprend l'étape consistant à établir à une valeur prédéterminée le bit correspondant à une fenêtre si :
- une minorité d'échantillons est à ladite valeur prédéterminée,
- le nombre de transitions (NT) dans la fenêtre est égal à 1, et
- le dernier échantillon (LSV) de la fenêtre précédente, le bit précédent (LbV), le bit estimé suivant (NbV), et le premier échantillon (NSV) de la fenêtre suivante sont à la valeur complémentaire de ladite valeur prédéterminée.

## Patentansprüche

1. Schaltung zur Wiederherstellung bzw. Rückgewinnung von mittels eines asynchronen Signals (S) übertragenen Bits, mit:
- einem Komparator (14) zum Vergleich des Signalpegels mit einem Bezugspegel (Vref);
- einer Sampling-Abtastschaltung (18), welche für jedes einem Bit entsprechende Zeitintervall mehrere (N) Samplewerte der Ausgangsgröße des Komparators liefert,
- einer Schaltung (22), welche eine Aufeinanderfolge von Fenstern bestimmt, deren jedes einem dieser Bits entspricht;
**dadurch gekennzeichnet**, daß die Schaltung umfaßt:
- eine Erfassungs- bzw. Aufnahmeschaltung (20), welcher die Samplewerte zugeführt werden und die für jedes Fenster die Anzahl (N1) von Samplewerten, die einen ersten logischen Wert besitzen, die Anzahl (NT) von Sampleübergängen, sowie einen einem benachbarten Fenster zugeordneten Randwert liefert; sowie
- eine Auswertschaltung (24) zur Korrektur des Bezugspegels und/oder der Ausrichtung der Fenster relativ bezüglich den Bits, in Abhängigkeit von den Ausgangsgrößen der Erfassungs-bzw. Aufnahmeschaltung.

2. Verfahren zur Wiederherstellung bzw. Rückgewinnung von mittels eines Signals in asynchroner Weise übertragenen Bits, bei welchem der Signalpegel mit einem Bezugspegel (Vref) verglichen und das Vergleichsergebnis während jedes einem Bit entsprechenden Zeitintervalls einer vorgegebenen Anzahl von Sample-Abtastungen unterzogen wird,
**dadurch gekennzeichnet**, daß das Verfahren die folgenden Stufen umfaßt:
- in jedem einem dieser Bits entsprechenden Fenster wird die Anzahl (N1) von Samplewerten mit einem ersten logischen Wert und die Anzahl (NT) von Übergängen der Samplewerte gezählt; und
- der Bezugspegel und/oder die Anfangszeitpunkte der Fenster werden in Abhängigkeit von der Anzahl von Samplewerten mit dem ersten logischen Wert, von der Anzahl der Übergänge, und von einem einem benachbarten Fenster zugeordneten Randwert (BV) korrigiert.

3. Verfahren zur Bit-Wiederherstellung bzw. -Rückgewinnung nach Anspruch 2, dadurch gekennzeichnet, daß das Verfahren die folgenden Stufen umfaßt, wenn die Anzahl (NT) der Übergänge in einem laufenden Fenster gleich 1 ist:
- Vorverschiebung des Anfangszeitpunkts eines nächsten Fensters, wenn die Mehrzahl von Samplewerten einem Randwert (BV) entspricht; andernfalls
- Verzögern des Anfangszeitpunkts eines nächsten Fensters.

4. Verfahren zur Bit-Wiederherstellung bzw. -Rückgewinnung nach Anspruch 2, dadurch gekennzeichnet, daß es die folgenden Stufen umfaßt, falls die Anzahl (NT) von Übergängen gleich 2 ist:
- Verringerung des Bezugsspegels (Vref), wenn die Anzahl (N1) von Samplewerten mit einem hohen Pegel kleiner als die vorgegebene Anzahl (N) einer vorgegebenen Größe ist und der Randwert (BV) einen hohen Pegel aufweist; und
- Erhöhung des Bezugspegels, wenn die Anzahl von Samplewerten mit einem niedrigen Pegel kleiner als die vorgegebene Anzahl (N) einer vorgegebenen Größe ist und der Randwert einen hohen Pegel aufweist.

5. Verfahren zur Bit-Wiederherstellung bzw. -Rückgewinnung nach einem der Ansprüche 3 und 4, dadurch gekennzeichnet, daß eine Korrektur in Gestalt einer Vorverschiebung oder Verzögerung des Anfangszeitpunkts eines nächsten Fensters oder einer Erhöhung oder Verringerung des Bezugspegels (Vref) nur vorgenommen wird, wenn der ihnen zugrundeliegende Zustand Wiederholungscharakter aufweist.

6. Verfahren zur Bit-Wiederherstellung bzw. -Rückgewinnung nach Anspruch 2, dadurch gekennzeichnet, da es die folgenden Stufen umfaßt:
- das einem Fenster entsprechende Bit wird mit einem vorgegebenen Wert festgestellt, wenn die Anzahl (NT) von Übergängen gleich 2 ist, die Anzahl von Samplewerten mit dem vorgegebenen Wert wenigstens gleich 1 ist, und der Randwert gleich dem Komplement des vorgegebenen Werts ist; und
- in den anderen Fällen wird der Bitwert mit dem Wert der Mehrzahl der Samplewerte des Fensters festgestellt.

7. Verfahren zur Bit-Wiederherstellung bzw. Rückgewinnung nach Anspruch 2, dadurch gekennzeichnet, daß es die folgenden Stufen umfaßt:
- Vornahme einer Anfangseinstellung der Periode der Aufeinanderfolge der Fenster und Beibehaltung dieser Periode während der Übertragung einer Bit-Serie (11); sowie
- Bestimmen bzw. Feststellen des Betrags jedes Bits durch Mehrheitsvotum, ausgenommen die Fälle, in denen mehrere Randwerte (BV) unter dem Betrag des letzten Samplewerts (LSV) des vorhergehenden Fensters, dem Wert des letzten Fensters (LbV), dem Betrag des ersten Samplewerts (NSV) des folgenden Fensters , und dem geschätzten Wert des nächsten Bits (NbV) repräsentativ für das Vorliegen eines einem isolierten Bit entsprechenden kurzen Impulses des Signals sind.

8. Verfahren zur Bit-Wiederherstellung bzw. -Rückgewinnung nach Anspruch 7, dadurch gekennzeichnet, daß es die Stufe der Feststellung eines vorgegebenen Wertes für das einem Fenster entsprechende Bit umfaßt, wenn:
- eine Minderheit von Samplewerten den genannten vorgegebenen Wert besitzen,
- die Anzahl (NT) von Übergängen in dem Fenster gleich 1 ist,
- der letzte Samplewert (LSV) des vorhergehenden Fensters den genannten vorgegebenen Wert besitzt, und
- das vorhergehende Bit (LbV) und der erste Samplewert (NSV) des folgenden Fensters den zu dem genannten vorgegebenen Wert komplementären Wert aufweisen.

9. Verfahren zur Bit-Wiederherstellung bzw. -Rückgewinnung nach Anspruch 7, dadurch gekennzeichnet, daß es die Stufe der Feststellung eines vorgegebenen Wertes für das einem Fenster entsprechende Bit umfaßt, wenn:
- eine Minderheit von Samplewerten den genannten vorgegebenen Wert besitzen,
- die Anzahl (NT) von Übergängen in dem Fenster gleich 1 ist,
- der letzte Samplewert (LSV) des vorhergehenden Fensters und das letzte Bit (LbV) gleich sind,
- das geschätzte folgende Bit (NbV) und der erste Samplewert (NSV) des folgenden Fensters voneinander verschieden sind,
- und das letzte Bit (LbV) und das geschätzte folgende Bit (NbV) den zu dem genannten vorgegebenen Wert komplementären Wert besitzen.

10. Verfahren zur Bit-Wiederherstellung bzw. -Rückgewinnung nach Anspruch 7, dadurch gekennzeichnet, daß es die Verfahrensstufe der Feststellung eines vorgegebenen Werts für das einem Fenster entsprechende Bit umfaßt, wenn :
- eine Minderheit von Samplewerten den genannten vorgegebenen Wert besitzen,
- die Anzahl (NT) von Übergängen in dem Fenster gleich 1 ist, und
- der letzte Samplewert (LSV) des vorhergehenden Fensters, das vorhergehende Bit (LbV), das folgende geschätzte Bit (NbV), und der erste Samplewert (NSV) des folgenden Fensters den zu dem genannten vorgegebenen Wert komplementären Wert besitzen.

## Claims

1. A circuit for restoring bits transmitted by an asynchronous signal (S), including:
- a comparator (14) of the signal level with a reference level (Vref);
- a sampling circuit (18) supplying several (N) samples of the comparator output for each time interval corresponding to a bit;
- a circuit (22) for determining a succession of windows, each of which corresponds to one of said bits; characterized in that it comprises:
- an acquisition circuit (20) receiving the samples and supplying, for each window, the number (N1) of samples which have a first logic value, the number (NT) of sample transitions, and a border value (BV) associated to an adjacent window; and
- an estimation circuit (24) for correcting the reference level and/or the alignment of the windows on the bits according to the outputs of the acquisition circuit.

2. A method for restoring bits transmitted asynchronously by a signal (S), wherein the signal level is compared to a reference level (Vref) and the result of the comparison is sampled a predetermined (N) number of times during each time interval corresponding to a bit, characterized in that it includes the following steps:
- in each window corresponding to one of said bits, counting the number (N1) of samples at a first logic value and the number (NT) of transitions of the samples; and
- correcting the reference level and/or the beginnings of the windows, according to the number of samples at the first value, the number of transitions, and a border value (BV) associated to an adjacent window.

3. A method for restoring bits according to claim 2, characterized in that it includes the following steps when the number of transitions (NT) in a current window is 1:
- advancing the beginning of a next window if the majority of the samples correspond to the border value (BV); otherwise
- delaying the beginning of a next window.

4. A method for restoring bits according to claim 2, characterized in that it includes the following steps when the number of transitions (NT) in a current window is 2:
- decreasing the reference level (Vref) if the number (N1) of samples at a high level is lower than a predetermined number (N) by a predetermined amount and the border value (BV) is at a low level; and
- increasing the reference level if the number of samples at a low level is lower than the predetermined number (N) by a predetermined amount and the border value is at a high level.

5. A method for restoring bits according to any of claim 3 to 4, characterized in that a correction consisting of advancing or delaying the beginning of a further window, or of increasing or decreasing the reference level (Vref), is performed only if the condition which necessitates this correction occurs repeatedly.

6. A method for restoring bits according to claim 2, characterized in that it includes the following steps:
- establishing the bit corresponding to a window at a predetermined value if the number of transitions (NT) is 2, the number of samples at the predetermined value is at least 1, and the border value is equal to the complement of the predetermined value; and
- in the other cases, establishing the bit value at the majority value of the window samples.

7. A method for restoring bits according to claim 2, characterized in that it includes the following steps:
- achieving an initial adjustment of the period of succession of the windows and maintaining this period during the transmission of a series of bits (11); and
- determining the value of each bit by a majority vote except in cases where several border values (BV) among the value of the last sample of the previous window (LSV), the value of the last bit (LbV), the value of the first sample of the next window (NSV), and the estimated value of the next bit (NbV), are representative of the existence of a short pulse of said signal which corresponds to an isolated bit.

8. A method for restoring bits according to claim 7, characterized in that it includes the step of establishing at a predetermined value the bit corresponding to a window if:
- a minority of samples is at said predetermined value;
- the number of transitions (NT) in the window is equal to 1;
- the last sample (LSV) of the previous window is at said predetermined value; and
- the previous bit (LbV) and the first sample (NSV) of the next window are at a value complementary to said predetermined value.

9. A method for restoring bits according to claim 7, characterized in that it includes the step of establishing at a predetermined value the bit corresponding to a window if:
- a minority of samples is at said predetermined value;
- the number of transitions (NT) in the window is equal to 1;
- the last sample (LSV) of the previous window and the last bit (LbV) are equal;
- the estimated next bit (NbV) and the first sample (NSV) of the next window are different; and
- the last bit (LbV) and the estimated next bit (NbV) are at a value complementary to said predetermined value.

10. A method for restoring bits according to claim 7, characterized in that it includes the step of establishing at a predetermined value the bit corresponding to a window if:
- a minority of samples is at said predetermined value;
- the number of transitions (NT) in the window is equal to 1; and
- the last sample (LSV) of the previous window, the previous bit (LbV), the estimated next bit (NbV), and the first sample (NSV) of the next window are at a value complementary to said predetermined value.
